**Europäisches Patentamt**

**European Patent Office**

**Office européen des brevets**

(19)

(11) Veröffentlichungsnummer: **0 346 664**
**A1**

# (12) EUROPÄISCHE PATENTANMELDUNG

(21) Anmeldenummer: **89109547.3**

(22) Anmeldetag: **26.05.89**

(51) Int. Cl.⁴: **H03L 7/14 , G11B 19/28**

(30) Priorität: **16.06.88 DE 3820477**

(43) Veröffentlichungstag der Anmeldung:
**20.12.89 Patentblatt 89/51**

(84) Benannte Vertragsstaaten:
**ES GR**

(71) Anmelder: **Deutsche Thomson-Brandt GmbH**
**Hermann-Schwer-Strasse 3 Postfach 1307**
**D-7730 Villingen-Schwenningen(DE)**

(72) Erfinder: **Storz, Dieter**
**Wiesenwegle 7**
**D-7233 Lauterbach(DE)**
Erfinder: **Baas, Dieter**
**Sofienstrasse 10**
**D-7640 Kehl(DE)**

(54) **Phasenregelkreis.**

(57) Um den lästigen Abgleich von Hand bei der Produktion und um Schwankungen der Drehzahl sowie eine damit verbundene Verschlechterung der Tonwiedergabe infolge Alterung der Bauteile und infolge Temperaturdrift zu vermeiden, wird ein automatischer Abgleich durchgeführt. Hierzu wird der Regler (R) des Phasenregelkreises vom Nachlaufoszillator (VCO) getrennt. Der Ausgang des Nachlaufoszillators (VCO) ist mit dem ersten Eingang eines Phasenvergleichers (P2) verbunden, dessen zweitem Eingang die Bezugsfrequenz (BF) zugeführt wird. Ein Mikroprozessor (MP), dessen Eingang (E) mit dem Ausgang des Phasenvergleichers (P2) und dessen Ausgang (A1) mit dem Eingang des Nachlaufoszillators (VCO) verbunden ist, ändert die Spannung an seinem Ausgang (A1) so lange, bis die Frequenz am Ausgang des Nachlaufoszillators (VCO) mit der Bezugsfrequenz (BF) übereinstimmt. Diese Spannung behält der Mikroprozessor (MP) bei. Der Regler (R) wird nun wieder mit dem Nachlaufoszillator (VCO) verbunden. Der Phasenregelkreis ist jetzt abgeglichen und betriebsbereit. Bei einem CD-Spieler kann der Abgleich beispielsweise jedesmal beim Einschalten, beim Wechsel einer CD-Platte oder während einer Pause zwischen zwei Musikstücken erfolgen.

EP 0 346 664 A1

## Phasenregelkreis

Die Erfindung betrifft einen Phasenregelkreis, bei dem der Ausgang eines ersten Phasenvergleichers, in dem die Istfrequenz mit der Bezugsfrequenz verglichen wird, mit dem Eingang eines ersten Reglers verbunden ist, dessen Ausgang mit dem Eingang eines Nachlaufoszillators verbunden ist.

In U.Tietze, Ch. Schenk, Halbleiter-Schaltungstechnik, 4. Auflage, Springer-Verlag, 1978 ist auf Seite 683 - 684 ein Phasenregelkreis, eine sogenannte phase-locked-loop beschrieben.

Phasenregelkreise, häufig mit PLL abgekürzt, dienen z.B. in CD-Spielern dazu, aus dem EFM-Signal, dem nach dem eight-to-fourteen-Code codierten und optisch von der CD-Platte gelesenen Datensignal, das Synchronsignal zur Regelung der Drehzahl des Plattenantriebs zu gewinnen. Die Regelung der Drehzahl des Plattenantriebs ist nötig, um eine gleichbleibende Bitrate im Datenfluß zu gewährleisten.

Ein erster Nachteil besteht nun darin, daß bei der Produktion eines CD-Spielers der Nachlaufoszillator des Phasenregelkreises durch Abgleich von Hand auf die Bezugsfrequenz eingestellt werden muß, denn Einstellarbeiten von Hand sind stets zeitaufwendig und teuer.

Ein zweiter Nachteil zeigt sich jedoch erst während des Betriebs eines CD-Spielers, wenn sich durch Temperaturdrift oder durch Alterung der Bauteile der PLL im Laufe der Zeit bedingt die Parameter der einzelnen Bauteile ändern und zu einer allmählichen zunächst kaum wahrnehmbaren Verschlechterung der Tonwiedergabe führen.

Es ist daher Aufgabe der Erfindung, bei einem Phasenregelkreis den nachteiligen Abgleich von Hand zu vermeiden und für einen von Alterung der Bauteile und von Temperaturdrift weitestgehend unabhängigen störungsfreien Betrieb zu sorgen.

Die Erfindung löst diese Aufgabe dadurch, daß der Ausgang eines zweiten Reglers mit dem Eingang des Nachlaufoszillators verbunden ist, daß der Ausgang des Nachlaufoszillators mit dem ersten Eingang eines zweiten Phasenvergleichers verbunden ist, dessen zweitem Eingang die Bezugsfrequenz zugeführt wird und dessen Ausgang mit dem Eingang des zweiten Reglers verbunden ist, daß zum automatischen Abgleich des Phasenregelkreises der erste Regler vom Nachlaufoszillator getrennt wird, daß der zweite Regler den Wert an seinem Ausgang so lange ändert, bis die Frequenz am Ausgang des Nachlaufoszillators mit der Bezugsfrequenz übereinstimmt, daß nach dem Abgleich der zweite Regler diesen Wert unabhängig vom Wert am Ausgang des zweiten Phasenvergleichers beibehält und der erste Regler wieder mit dem Eingang des Nachlaufoszillators verbunden wird.

Es zeigen
Figur 1 ein erstes Ausführungsbeispiel
Figur 2 ein zweites Ausführungsbeispiel
Figur 3 ein drittes Ausführungsbeispiel
Figur 4 ein viertes Ausführungsbeispiel der Erfindung.

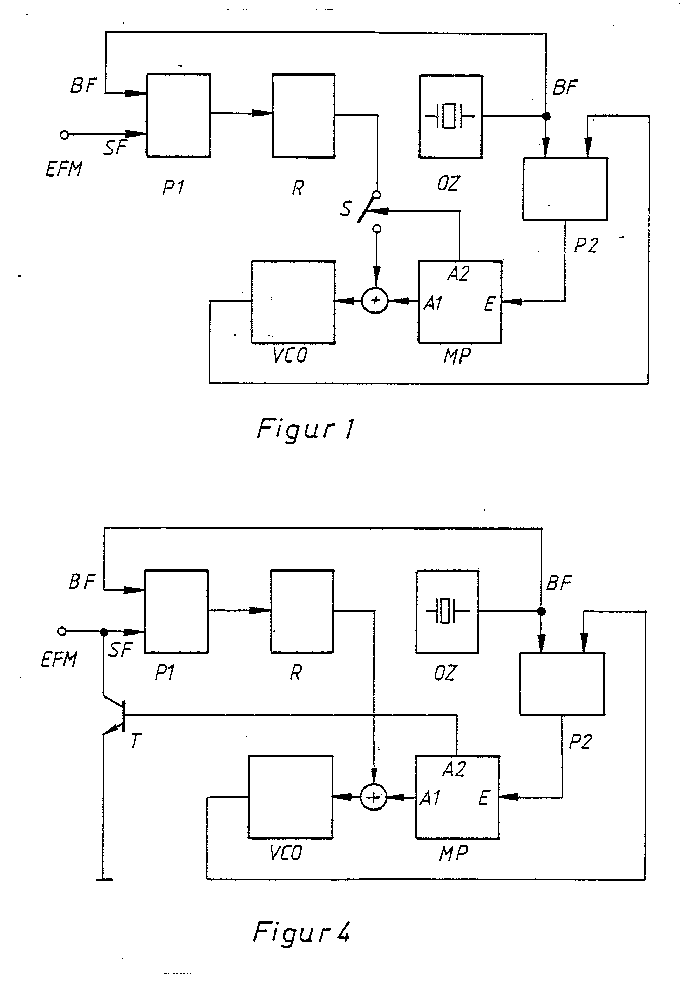

Anhand des in Figur 1 gezeigten Ausführungsbeispieles wird die Erfindung nun zuerst beschrieben und anschließend erläutert.

In der Figur 1 wird das EFM-Signal dem ersten Eingang eines Phasenvergleichers P1 zugeführt, dessen Ausgang mit dem Eingang eines ersten Reglers R verbunden ist. Der Ausgang eines Quarzoszillators OZ, der die Bezugsfrequenz BF erzeugt, ist mit dem zweiten Eingang des Phasenvergleichers P1 und eines weiteren Phasenvergleichers P2 verbunden, dessen erster Eingang mit dem Ausgang eines Nachlaufoszillators VCO verbunden ist. Der Eingang des Nachlaufoszillators VCO, beispielsweise ein spannungsgesteuerter Oszillator, ist mit dem ersten Eingang A1 eines als zweiten Regler vorgesehenen Mikroprozessors MP und über einen steuerbaren Schalter S mit dem Ausgang des ersten Reglers R verbunden. Der Eingang E des Mikroprozessors MP ist mit dem Ausgang des Phasenvergleichers P2 verbunden. Der Steuereingang des steuerbaren Schalters S ist mit dem zweiten Ausgang A2 des Mikroprozessors MP verbunden.

Zum Abgleich des Phasenregelkreises öffnet der Mikroprozessor MP den steuerbaren Schalter S, so daß der Ausgang des ersten Reglers (R) vom Eingang des Nachlaufoszillators OZ getrennt wird, und ändert nun die Spannung an seinem Ausgang A1 so lange, bis die Frequenz am Ausgang des spannungsgesteuerten Oszillators VCO mit der Bezugsfrequenz BF des Quarzoszillators OZ übereinstimmt. Anschließend behält der Mikroprozessor MP diese Spannung an seinem Ausgang A1 bei und schließt den steuerbaren Schalter S. Der Phasenregelkreis ist jetzt abgeglichen und betriebsbereit.

Der automatische Abgleich des Phasenregelkreises kann z.B. gemäß Unteranspruch 5 jedesmal beim Einschalten des CD-Spielers vorgenommen werden. Er kann aber auch, wie in den Unteransprüchen 6 und 7 angegeben, jedesmal vor dem Abspielen einer neuen CD-Platte oder wenn keine Daten wiedergegeben werden, beispielsweise in einer Pause zwischen zwei Musikstücken, durchgeführt werden. Auch wenn sich die Abtastvorrichtung des CD-Spielers in einer Warteposition befindet, weil die Bedienperson beispielsweise ein Programm in den CD-Spieler eingibt, kann der Abgleich erfolgen. Bei zwei weiteren Ausführungsbeispielen erfolgt der Abgleich, wenn die Fehlerrate im Datensignal einen vorgebbaren Schwellwert übersteigt oder wenn der CD-Spieler vollkommen ausfällt. Beim Spurspringen läßt sich der Abgleich ebenfalls durchführen.

Wenn der Abgleich bei bereits laufendem Plattenantrieb, z.B. zwischen zwei Musikstücken, durchgeführt wird, wird bei einem weiteren Ausführungsbeispiel die zuletzt vor dem Abgleich eingestellte Drehzahl des Plattenantriebs für die Dauer des Abgleichs beibehalten. Diese Maßnahme hat bei einem System, das mit einer konstanten Bahngeschwindigkeit arbeitet - ein sogenanntes constant velocity system - den Vorteil, daß die Drehzahl des Plattenantriebs nach dem Abgleich in der Nähe des Sollwertes liegt.

Selbstverständlich ist eine Kombination aller in den Unteransprüchen 4 - 8 beschriebenen Merkmale möglich.

Wenn ein CD-Spieler mit dem erfindungsgemäßen Phasenregelkreis ausgerüstet ist, entfällt nicht nur der lästige Abgleich von Hand bei der Produktion, sondern es wird auch wegen des häufig vorgenommenen Neuabgleichs für eine gleichbleibend gute Tonwiedergabe gesorgt, weil Änderungen der Parameter einzelner Bauteile infolge Alterung oder infolge Temperaturschwankungen bei jedem Neuabgleich kompensiert werden.

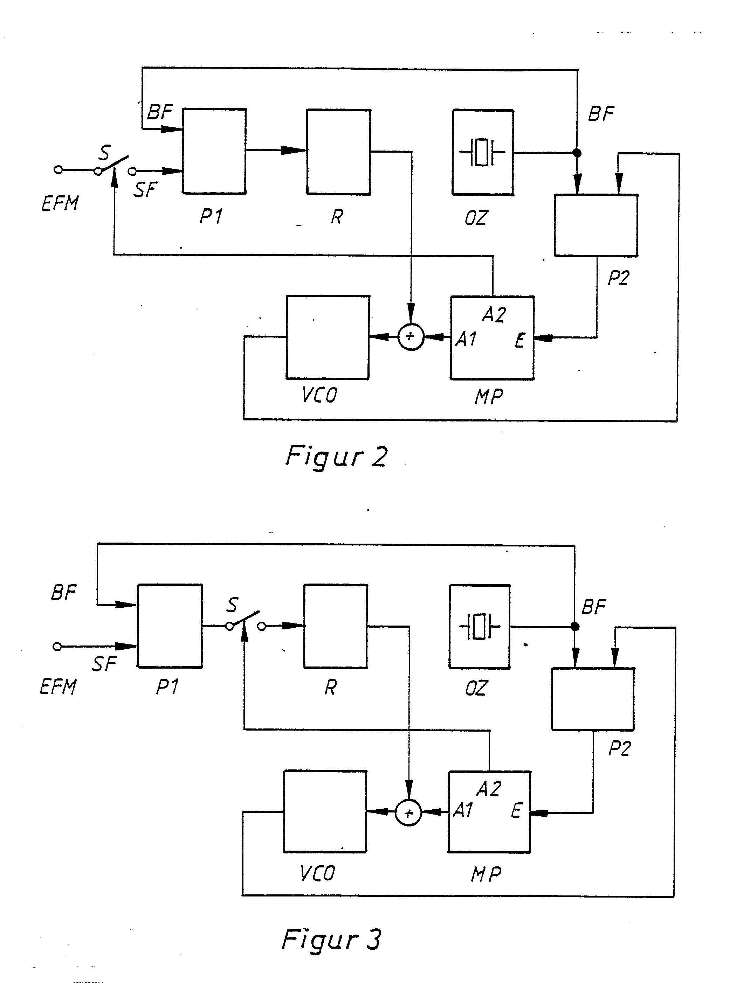

Wie in Figur 2 gezeigt ist, kann der steuerbare Schalter S vor dem ersten Eingang des Phasenvergleichers P1 oder, wie in Figur 3 dargestellt ist, zwischen dem Phasenvergleicher P1 und dem Regler R vorgesehen sein. Bei geschlossenem Schalter S ist der Ausgang des Reglers R niederohmig, bei geöffnetem Schalter S dagegen hochohmig. Daher ist der Regler R nur im ersten Fall wirksam; im zweiten Fall ist er dagegen unwirksam geschaltet.

In Figur 4 ist der erste Eingang des Phasenvergleichers P1 über die Kollektor-Emitter-Strecke eines Transistors T, dessen Basis mit dem Ausgang A2 des Mikroprozessors MP verbunden ist, mit Bezugspotential verbunden. Während des Abgleichs des Phasenregelkreises wird der Eingang des Phasenvergleichers P2 vom Transistor T auf Bezugspotential gezogen. Weil dadurch der Ausgang des Reglers R hochohmig wird, wirkt der Regler R nicht mehr auf die PLL. Er ist unwirksam geschaltet. Bei gesperrtem Transistor T ist der Regler R dagegen wirksam, weil sein Ausgang in diesem Fall niederohmig ist.

## Ansprüche

1. Phasenregelkreis, bei dem der Ausgang eines ersten Phasenvergleichers (P1), in dem die Istfrequenz (IF) mit der Bezugsfrequenz (BF) verglichen wird, mit dem Eingang eines ersten Reglers (R) verbunden ist, dessen Ausgang mit dem Eingang eines Nachlaufoszillators (VCO) verbunden ist, dadurch gekennzeichnet, daß der Ausgang (A1) eines zweiten Reglers (MP) mit dem Eingang des Nachlaufoszillators (VCO) verbunden ist, daß der Ausgang des Nachlaufoszillators (VCO) mit dem ersten Eingang eines zweiten Phasenvergleichers (P2) verbunden ist, dessen zweitem Eingang die Bezugsfrequenz (BF) zugeführt wird und dessen Ausgang mit dem Eingang (E) des zweiten Reglers (MP) verbunden ist, daß zum automatischen Abgleich des Phasenregelkreises der erste Regler (R) vom 'Nachlaufoszillator (VCO) getrennt wird, daß der zweite Regler (MP) den Wert an seinem Ausgang (A1) so lange ändert, bis die Frequenz am Ausgang des Nachlaufoszillators (VCO) mit der Bezugsfrequenz (BF) übereinstimmt, daß nach dem Abgleich der zweite Regler (MP) diesen Wert unabhängig vom Wert am Ausgang des zweiten Phasenvergleichers (P2) beibehält und der erste Regler (R) wieder mit dem Eingang des Nachlaufoszillators (VCO) verbunden wird.

2. Phasenregelkreis nach Anspruch 1, dadurch gekennzeichnet, daß der Ausgang eines Quarzoszillators (OZ), der die Bezugsfrequenz (BF) erzeugt, mit dem zweiten Eingang des ersten und des zweiten Phasenvergleichers (P1, P2) verbunden ist, daß der erste Ausgang (A1) des zweiten Reglers (MP) mit dem Eingang des Nachlaufoszillators (VCO) und der zweite Ausgang (A2) des zweiten Reglers. (MP) mit dem Steuereingang eines steuerbaren Schalters (S) verbunden ist, der den ersten Regler (R) unwirksam schaltet.

3. Phasenregelkreis nach Anspruch 2, dadurch gekennzeichnet, daß der steuerbare Schalter (S) entweder vor dem ersten Eingang des ersten Phasenvergleichers (P1) oder zwischen dem ersten Phasenvergleicher (P1) und dem ersten Regler (R) oder zwischen dem ersten Regler (R) und dem Nachlaufoszillator (VCO) liegt, daß der zweite Regler (MP) zum Abgleich des Phasenregelkreises den steuerbaren Schalter (S) öffnet und nach dem Abgleich wieder schließt.

4. Phasenregelkreis nach Anspruch 1, 2 oder 3, dadurch gekennzeichnet, daß der Phasenregelkreis in einem CD-Spieler aus dem EFM-Signal, das dem ersten Eingang des ersten Phasenvergleichers (P1) zugeführt wird, das Synchronsignal zur Regelung des Plattenantriebs erzeugt.

5. Phasenregelkreis nach Anspruch 4, dadurch gekennzeichnet, daß der Abgleich jedesmal nach dem Einschalten des CD-Spielers erfolgt.

6. Phasenregelkreis nach Anspruch 4 oder 5, **dadurch gekennzeichnet**, daß der Abgleich jedesmal vor dem Abspielen einer neuen CD-Platte erfolgt.

7. Phasenregelkreis nach Anspruch 4, 5 oder 6, **dadurch gekennzeichnet**, daß der Abgleich erfolgt, wenn keine Datensignale wiedergegeben werden.

8. Phasenregelkreis nach Anspruch 4, 5, 6 oder 7, **dadurch gekennzeichnet**, daß der Abgleich durchgeführt wird, wenn die Fehlerrate im Datensignal einen vorgebbaren Schwellwert überschreitet.

9. Phasenregelkreis nach Anspruch 4, 5, 6, 7 oder 8, **dadurch gekennzeichnet**, daß der Abgleich bei Ausfall der Datenwiedergabe erfolgt.

10. Phasenregelkreis nach Anspruch 4, 5, 6, 7, 8 oder 9, **dadurch gekennzeichnet**, daß der Abgleich während des Spurspringens erfolgt.

11. Phasenregelkreis nach Anspruch 4, 5, 6, 7, 8, 9 oder 10, **dadurch gekennzeichnet**, daß der Abgleich in der Pause zwischen zwei Musikstücken erfolgt.

12. Phasenregelkreis nach Anspruch 4, 5, 6, 7, 8, 9, 10 oder 11, **dadurch gekennzeichnet**, daß die zuletzt vor dem Abgleich eingestellte Drehzahl des Plattenantriebs für die Dauer des Abgleichs beibehalten wird.

*Figur 1*

*Figur 4*

Figur 2

Figur 3

V87/061

Europäisches Patentamt

# EUROPÄISCHER RECHERCHENBERICHT

Nummer der Anmeldung

EP 89 10 9547

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | PATENT ABSTRACTS OF JAPAN, Band 10, Nr. 177 (P-470)[2233], 21. Juni 1986, Seite 3 P 470; & JP-A-61 24 055 (MATSUSHITA ELECTRIC IND. CO. LTD) 01-02-1986 * Zusammenfassung; Figur * | 1-5,7, 12 | H 03 L 7/14 G 11 B 19/28 |
| A | PATENT ABSTRACTS OF JAPAN, Band 9, Nr. 105 (P-354)[1828], 9. Mai 1985; & JP-A-59 227 069 (AIWA K.K.) 20-12-1984 * Zusammenfassung; Figur * | 1-5 | |
| A | GB-A-2 128 780 (NIPPON VICTOR K.K.) * Figur 2; Seite 3, Zeilen 16-25; Seite 4, Zeilen 12-17 * | 1,2,4 | |
| A | EP-A-0 049 136 (TOKYO SHIBAURA DENKI K.K.) * Figur 4; Seite 9, Zeilen 16-32 * | 1,2,4 | |

| | RECHERCHIERTE SACHGEBIETE (Int. Cl.4) |
|---|---|
| | H 03 L G 11 B |

Der vorliegende Recherchenbericht wurde für alle Patentansprüche erstellt

| Recherchenort | Abschlußdatum der Recherche | Prüfer |
|---|---|---|
| DEN HAAG | 30-08-1989 | PEETERS M.M.G. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
........................................................................
& : Mitglied der gleichen Patentfamilie, übereinstimmendes Dokument

EPO FORM 1503 03.82 (P0403)